# EUROPEAN PATENT APPLICATION

(11) **EP 2 844 045 A1**
(43) Date of publication of application: **04.03.2015**
(21) Application number: 13306196.0
(22) Date of filing: 03.09.2013
(51) Int. Cl.: H05K 5/02, H05K 7/20, H04B 1/036

(54) **Cooling improvement system for assets within an enclosure**

(71) Applicant: ALCATEL LUCENT, 92100 Boulogne-Billancourt (FR)
(72) Inventor: Akalanne, Lucius Chidi, Swindon, Wiltshire WI SN5 7 YT (GB); Kerslake, Simon, Swindon, Wiltshire WI SN5 7YT (GB)
(74) Representative: Shamsaei Far, Hassan

(57) **Abstract**

A cooling improvement system for assets (EL) within an enclosure (EN) of which at least one side wall, which is not provided with an external heat-sink (HS1; HS2) with fins, is provided with a weatherized membrane filter (FI1; FI2). In a preferred embodiment, the enclosure (EN) comprises internal chambers separated by internal walls provided with a weatherized membrane filter according to the invention. The cooling improvement system is completely passive and do not require or consume any electrical power to provide the additional cooling. Additionally, the weatherized or hydrophobic membrane filter provides weight reduction, emits no noise, occupies no additional space and provides improved reliability while maintaining weather ingress protection to IP67.

## Description

The present invention relates to a cooling improvement system for assets within an enclosure of which at least one wall is not provided with an external heat-sink with fins.

The best known solution to improve cooling for assets or electronic equipment such as, e.g., a Remote Radio Head RRH trapped heat, while maintaining enclosure ingress protected to IP65 (e.g. known from the Internet at < http://en.wikipedia.org/wiki/IP_Code >), is to increase the size of the heat-sink located on walls of the enclosure.

However, increasing the size of the heat-sink also increases weight and cost.

Another approach is to introduce fans to provide more cooling over the RRH fins.

This negatively impacts reliability, while the fans also occupy more premium real-estate and they also generate unwanted acoustic noise.

Other cooling alternatives can be to insert heat-pipes within the RRH enclosure and extract the heat to the external heat-sink.

This approach not only requires real-estate within the enclosure but also requires enlarging the heat-sink to cope with the additional waste power.

A "Ventilated Housing" is for instance disclosed in the US Patent US-6,309,296-B1 by SCHWENK HANS-MARTIN [DE] et al (priority DE-1998110945 of 1998.03.13).

Therein, a double-walled housing for the accommodation of electrical and electronic components possesses on its inner wall a ventilation opening. In a gap between inner wall and external wall sits an air filter with a cylindrical filter cartridge. This air filter is drawn up on a supporting lattice, which is fastened to a removable assembly ring. A closeable service opening with a cover is in the external wall and aligns with the ventilation opening.

This housing or enclosure has no Ingress Protection IP67 and encourages thermal pollution and dust water reversals, while its form and function occupies significant enclosure real estate. Indeed, it uses a double walled enclosure with a filter on the inlet while the exit is open to ambient and so is not an IP67 enclosure. This solution risks significant flow and dust reversals that can contaminate or corrode assets within the enclosure.

Another "Fresh Air enclosure cooling" system is known from PENTAIR^{™} as available on the Internet at
< http://www.mcleancoolingtech.com/getattachment/1bb9920c-d3d9-4437-8f5d-b0f8c4647ad8/PL78.aspx >.

This other known enclosure uses a fan, requires electrical power, emits acoustic noise and promotes thermal pollution.

This other solution uses a bulky filter assembly on the inlet and also on the outlet of the enclosure but the flow is driven by the inclusion of expensive fans which require electrical power to drive them. The fans also create acoustic pollution and occupy significant real-estate.

An object of the present invention is to provide additional or improved cooling to assets within an enclosure of the above known type but with zero impact on enclosure size, and without increasing heat-sink size or introducing active devices such as axial or piezoelectric fans while maintaining enclosure IP67 water and dust ingress protection.

According to a characterizing embodiment of the invention, this object is achieved due to the fact that said one side wall without heat-sink is provided with a weatherized membrane filter.

The side walls of the enclosure that are not provided with heat-sinks are generally heavy metal plates. By replacing at least one of these heavy side walls or plates with a relatively lighter weatherized membrane filter, the unit is made naturally breathable with its environment and evacuates internal waste heat and power. The cooling process is driven by the temperature increase within the enclosure, which drives higher internal pressure (compared to ambient) that over-comes the filter membrane pressure drop and forces the evacuation of the internal hot air (waste power) to ambient.

Moreover, the present cooling improvement system is completely passive and requires nor consumes no electrical power to provide additional cooling. Additionally, the weatherized or hydrophobic membrane filter occupies no additional space, provides weight reduction, emits no noise, and provides improved reliability while maintaining weather ingress protection to IP67.

In a preferred characterizing embodiment of the present invention, said enclosure comprises a plurality of internal chambers, said chambers being separated by internal walls, each wall being provided with a weatherized membrane filter.

For thermal isolation between internal assets inside the enclosure, the only approach known in the art is to physically have separate chambers for each of the more dominant and less dominant dissipative assets. However, this known solution does not provide a thermal barrier between the more dominant and less dominant dissipative assets and in fact promotes thermal pollution between assets.

The characteristic feature of the present invention to provide weatherized membrane filters for separating the chambers provides a thermal barrier between the more dominant and less dominant dissipative assets and breaks thermal coupling and pollution between assets in the different chambers.

In a preferred characterizing embodiment of the present invention, said weatherized membrane filter is protected by a solar shield.

Also another characterizing embodiment of the present invention is that said weatherized membrane filter includes metal weave.

The metal weave included in the membrane filter provides additional EMC protection.

Further characterizing embodiments of the present cooling improvement system are mentioned in the appended claims.

It is to be noticed that the terms "comprising" or "including", used in the claims, should not be interpreted as being restricted to the means listed thereafter. Thus, the scope of an expression such as "a device comprising means A and B" should not be limited to an embodiment of a device consisting only of the means A and B. It means that, with respect to embodiments of the present invention, A and B are essential means of the device.

Similarly, it is to be noticed that the term "coupled", also used in the claims, should not be interpreted as being restricted to direct connections only. Thus, the scope of the expression such as "a device A coupled to a device B" should not be limited to embodiments of a device wherein an output of device A is directly connected to an input of device B. It means that there may exist a path between an output of A and an input of B, which path may include other devices or means.

The above and other objects and features of the invention will become more apparent and the invention itself will be best understood by referring to the following description of an embodiment taken in conjunction with the accompanying drawings wherein:
**Fig. 1** is a top view of an enclosure EN for assets EL and provided with a cooling improvement system FI1, FI2 according to the invention; and
**Fig. 2** is a side view of the enclosure EN shown at Fig. 1.

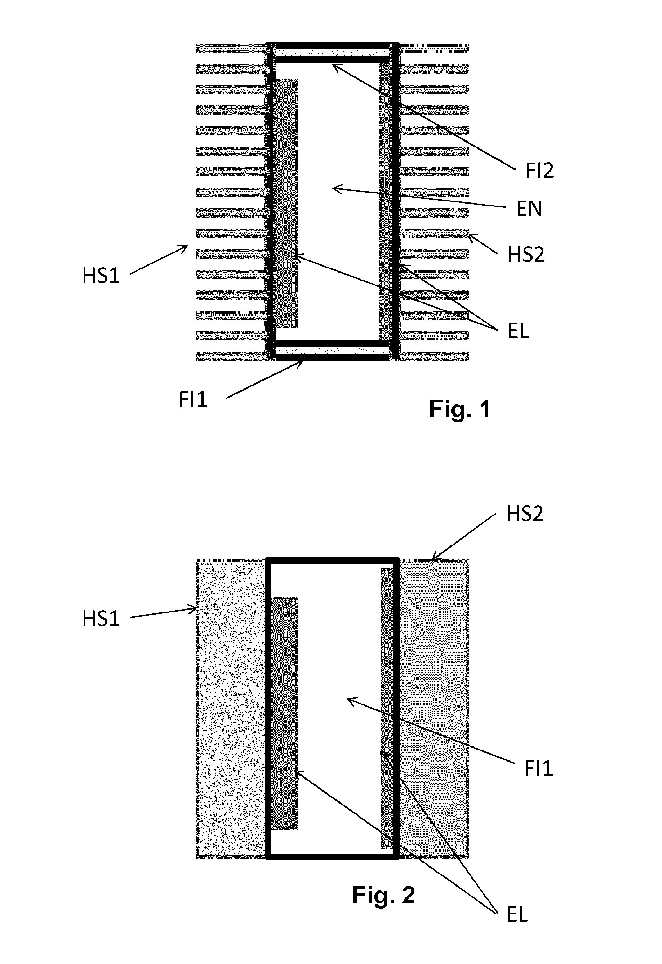

The unit or enclosure EN shown at the Figs. 1 and 2 is preferably, but not exclusively, a Remote Radio Head RRH housing internal assets or electronics EL and has at least two side walls provided with external heat-sinks HS1 and HS2 with fins. The other side walls of the enclosure are generally heavy metal plates.

The cooling provided by these heat-sinks HS1, HS2 is increased by a cooling improvement system according to the present invention.

This cooling improvement system comprises light weatherized or hydrophobic membrane filters FI1, FI2 advantageously replacing, at least partially, one or more heavy metal side plates of the enclosure that are not provided with heat-sinks.

The cooling improvement system is completely passive and do not require or consume any electrical power to provide the increase of cooling. Additionally, the weatherized or hydrophobic membrane filter provides weight reduction, emits no noise, occupies no additional space and provides improved reliability while maintaining weather ingress protection to IP67.

Owing to the cooling improvement system, the unit is made naturally breathable with its environment and can naturally evacuate internal waste heat and power. This improved cooling process is driven by the temperature increase within the enclosure EN, which drives higher internal pressure (compared to ambient) that overcomes the filter membrane pressure drop and forces the evacuation of internal hot air (waste power) to ambient.

In a variant application, the enclosure EN comprises several internal chambers (not shown). These chambers are separated by internal walls that are also provided with a weatherized membrane filter.

The weatherized membrane filter, separating the chambers inside the enclosure EN, forms a natural thermal barrier between a first chamber comprising the more dominant dissipative assets and a second chamber comprising the less dominant dissipative assets. Furthermore, the separating weatherized membrane filter significantly minimizes any thermal coupling and pollution between the assets in the different chambers.

As already mentioned, no electrical power is required to achieve large cooling benefit, whereby EMC (radiated & conducted) is also no risk. Also, no piezoelectric or axial fans are required, so audible acoustic emissions are fully eliminated, i.e. with zero impact on acoustic noise. The spatial real-estate and weight are reduced by more than 60% by replacing the metal sides of the enclosure EN with filter membranes.

Calculation based on typical NAR dust levels (PM10) of 25ug/m3 results in membrane filter field replacement every 13 years, which results in a significant cost reduction.

Furthermore, the enclosure remains compliant to weatherized protection of IP67 (dust and water ingress protection level) and internal temperatures remain sufficiently high (about 10°C greater than ambient) to avoid all likely hood of condensation occurring.

Computation fluid dynamics simulation analysis conducted on the present cooling improvement system showed a considerable improvement in cooling that would result in significant improvement in reliability (Telcordia SR332 Issue 3; Ref. Internet < http://telecom-info.telcordia.com/site-cgi/ido/docs.cgi?ID=SEARCH&DOCUMENT=SR-332& >) and costs as mentioned below:
- internal temperatures drop by more than 20°C;
- pressure on ingress seals reduced by more than 85%;
- filter internal temperature is 16°C cooler, resulting in a reliability improvement of 48%;
- cables are 16°C cooler, resulting in a cost saving of 20% for lower temp rated cables;
- radio & PSU are 2.5°C cooler, resulting in a reliability improvement of 7.5%; and
- PA is 1°C cooler, resulting in a reliability improvement of 3%.

The significant evacuation of waste heat and power not only reduces the internal temperatures and temperatures of assets but also reduces the internal pressure resulting in less stress on the enclosures environmental seals.

For some applications, the weatherized membrane filter may be protected by a solar shield (not shown).

A non-exhaustive list of embodiments of the present cooling improvement system is summarized below:
- the light weatherized or hydrophobic membrane filter FI1/ FI2 can be nano surface coated, so that external self cleaning naturally occurs;
- the membrane filter can have paint pigmentation so that it gives visual indications when the unit is too hot to touch;
- the membrane filter can be fitted with internal vanes to baffle cool air to selected regions internally;
- the membrane filter topology and size can be varied dependent on the magnitude of additional cooling required;
- the membrane filter can be designed with metal filaments, which can be electrically powered to generate electro-hydrodynamics to create ionic winds that further provide more internal cooling;
- the membrane filter can include metal weave to provide additional EMC protection if required;
- the membrane filter can also be used on individual assets like the Radio and Amplifier shields to benefit from addition local cooling.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. A cooling improvement system for assets (EL) within an enclosure (EN) of which at least one side wall is not provided with an external heat-sink (HS1; HS2) with fins,
**characterized in that** said one side wall without heat-sink is provided with a weatherized membrane filter (FI1; FI2).

2. The cooling improvement system according to claim **1**, **characterized in that** said enclosure (EN) comprises a plurality of internal chambers, said chambers being separated by internal walls, each wall being provided with a weatherized membrane filter.

3. The cooling improvement system according to claim **1**, **characterized in that** weatherized membrane filter replaces a relatively heavy metal plate as side wall of said enclosure (EN).

4. The cooling improvement system according to claim **3, characterized in that** only a portion of said plate is provided with a weatherized membrane filter.

5. The cooling improvement system according to claim **3, characterized in that** a plurality of plates are replaced a weatherized membrane filter.

6. The cooling improvement system according to claim **1, characterized in that** said weatherized membrane filter (FI1; FI2) is protected by a solar shield.

7. The cooling improvement system according to claim **1, characterized in that** said weatherized membrane filter (FI1; FI2) includes metal weave.

8. The cooling improvement system according to claim **1**, **characterized in that** the topology and size of said weatherized membrane filter (FI1; FI2) is dependent on the magnitude of additional cooling required.

## Amended claims

### Amended claims in accordance with Rule 137(2) EPC.

1. A weatherproofed enclosure (EN) for electronics (EL) comprising at least a first side wall provided with external heat-sink (HS1, HS2) with fins and at least a second side wall not provided with external heat-sink with fins, said at least second side wall being provided with a weatherized membrane filter (Fl1; Fl2),
**characterized in that** said enclosure (EN) comprises a plurality of internal chambers containing electronics, said chambers being separated by internal walls, each wall being provided with a weatherized membrane filter.

2. The weatherproofed enclosure according to claim **1, characterized in that** weatherized membrane filter replaces a relatively heavy metal plate as second side wall of said enclosure (EN).

3. The weatherproofed enclosure according to claim **2**, **characterized in that** only a portion of said plate is provided with a weatherized membrane filter.

4. The weatherproofed enclosure according to claim **2**, **characterized in that** a plurality of plates are replaced by a weatherized membrane filter.

5. The weatherproofed enclosure according to claim **1, characterized in that** said weatherized membrane filter (Fl1; Fl2) is protected by a solar shield.

6. The weatherproofed enclosure according to claim **1, characterized in that** said weatherized membrane filter (Fl1; Fl2) includes metal weave.

7. The weatherproofed enclosure according to claim **1**, **characterized in that** the topology and size of said weatherized membrane filter (Fl1; Fl2) is dependent on the magnitude of additional cooling required.
